# DEMANDE DE BREVET EUROPEEN

(11) **EP 4 576 991 A1**
(43) Date de publication de la demande: **25.06.2025**
(21) Numéro de dépôt: 24221776.8
(22) Date de dépôt: 19.12.2024
(51) Int. Cl.: H10D 30/40, H10D 48/00, H10D 62/10, H10D 64/27, B82Y 10/00

(54) **DISPOSITIF QUANTIQUE A QBITS SUPERPOSES ET CONTROLES LATERALEMENT**

(30) Priorité: 22.12.2023 FR 2315157
(71) Demandeur: Commissariat à l'Energie Atomique et aux Energies Alternatives, 75015 Paris (FR)
(72) Inventeur: NIEBOJEWSKI, Heimanu, 38054 GRENOBLE Cedex 09 (FR)
(74) Mandataire: Brevalex

(57) **Abrégé**

Dispositif électronique quantique doté :
- d'un premier ensemble de régions semi-conductrices (102L, 104L) comprenant une première région semi-conductrice inférieure (102L) et une première région semi-conducteur supérieure (104L), superposée à, et séparée de, la première région semi-conductrice inférieure par le biais d'une première zone de séparation » (ZS1) diélectrique,
- d'un deuxième ensemble de régions semi-conductrices (102R, 104R) comprenant une deuxième région semi-conductrice inférieure (102R) et une deuxième région semi-conducteur supérieure (104R), superposée à, et séparée de, la première région semi-conductrice inférieure par le biais d'une deuxième zone de séparation » (ZS2) diélectrique,

le premier ensemble de régions semi-conductrices (102L, 104L) étant disposé en vis-à-vis du deuxième ensemble de régions semi-conductrices (102R, 104R),
au moins une région diélectrique (RD) séparant le premier ensemble de régions semi-conductrices (102R, 104R) du deuxième ensemble de régions semi-conductrices (102R, 104R).

## Description

### DOMAINE TECHNIQUE ET ÉTAT DE LA TECHNIQUE ANTÉRIEURE

La présente demande se rapporte au domaine des dispositifs quantiques dans lesquelles au moins une informatique quantique basée sur un état quantique donné parmi au moins deux niveaux mesurables est utilisée comme vecteur d'information. Cet état quantique est appelé qubit ou bit quantique ou encore « quantum bit » en anglais.

Un type particulier de qubit est le qubit de spin lorsqu'on utilise le degré de liberté intrinsèque du spin d'électrons individuels pour coder l'information quantique.

Les qubits peuvent être formés dans un matériau semi-conducteur au sein de structures de confinement de tailles nanométriques et définies de manière électrostatique et ou physique. Ces structures de confinement sont typiquement appelées « points quantiques » ou « boites quantiques » (« quantum dots » en anglais).

Une boîte quantique se comporte comme un puits de potentiel confinant une ou plusieurs charges élémentaires (électrons ou trous) dans une région de semi-conducteur.

Pour mesurer l'état d'un qubit, il est connu de procéder à une conversion spin/charge qui permet de convertir l'état de spin des particules chargées en un état de charge des boites quantiques contenant lesdites particules. Il est alors nécessaire de mesurer cet état de charge afin d'en déduire l'état de spin des particules chargées avant conversion. Pour cela, un moyen de mesure de l'état de charge est en général disposé en regard ou à proximité de chaque boite quantique.

La lecture d'un qubit peut être par exemple réalisée en utilisant une autre boîte quantique appelée « ilot de lecture » ou « ilot de détection » couplée à celle du qubit destiné à être lu. Ces deux éléments forment deux puits de potentiel séparés par une barrière de potentiel.

Des dispositifs dans lesquels les ilots de détection et boites quantiques sont disposées en regard et dans un même plan parallèle au plan principal d'un substrat sur lequel les boites quantiques et les ilots de détection sont formées, sont connus.

Le document de R Pillarisetty "High Volume Electrical Characterization of Semiconductor Qubits", 2019 IEEE International Electron Devices Meeting (IEDM) propose par exemple un dispositif avec des boites quantiques formées dans un premier bloc semi-conducteur de forme allongée (« fin » selon la terminologie anglo-saxonne ») et des ilots de détection formées dans un deuxième bloc semi-conducteur de forme allongée et parallèle au premier bloc.

Il se pose le problème de réaliser un nouveau dispositif quantique et qui soit amélioré en termes de densité d'intégration tout en conservant de préférence une bonne sensibilité de détection.

### EXPOSÉ DE L'INVENTION

Selon un aspect, un mode de réalisation de la présente invention concerne un dispositif électronique quantique doté d'un substrat et sur ce substrat °:
- d'un ensemble de barreaux semi-conducteurs superposés comprenant au moins un barreau semi-conducteur inférieur et au moins une barreau semi-conducteur supérieur, le barreau semi-conducteur inférieur et le barreau semi-conducteur supérieur étant disposés l'un au-dessus de l'autre,
- un premier groupe de grilles superposées comprenant au moins une première grille inférieure et une première grille supérieure superposée à, et séparée de la première grille inférieure par une zone d'isolation, la première grille inférieure étant disposée en regard de, et apte à être couplée par couplage capacitif à, une première région du barreau semi-conducteur inférieur formant une premier boite quantique, la première grille supérieure étant disposée en regard de, et apte à être couplée par couplage capacitif à, une première région du barreau semi-conducteur supérieur formant un deuxième boite quantique,
- un deuxième groupe de grilles superposées comprenant une deuxième grille inférieure et une deuxième grille supérieure superposée à, et séparée de la deuxième grille inférieure par une zone d'isolation, la première grille inférieure étant disposée en regard d'une deuxième région du barreau semi-conducteur inférieur opposée à la première région du barreau semi-conducteur inférieur, la deuxième grille supérieure étant disposée en regard d'une deuxième région du barreau semi-conducteur supérieur opposée à la première région du barreau semi-conducteur supérieur, le premier groupe et le deuxième groupe de grilles étant agencés de sorte que ledit ensemble de barreaux semi-conducteurs est disposé entre le premier groupe de grilles superposées et le deuxième groupe de grilles superposées.

Un tel agencement à barreaux semi-conducteurs superposés et grilles latérales permet d'obtenir une densité de boites quantiques agencées sur plusieurs plans distincts dans une direction orthogonale au plan principal et un contrôle latéral amélioré de ces boites quantiques.

Avantageusement, le dispositif peut comprendre en outre :
- un troisième groupe de grilles superposées juxtaposé audit premier groupe de grilles, le troisième groupe de grilles superposées comprenant au moins une troisième grille inférieure séparée d'une troisième grille supérieure superposée à, et séparée de la troisième grille inférieure par une zone d'isolation, la troisième grille inférieure et la troisième grille supérieure étant disposées en regard, respectivement d'une troisième région semi-conductrice inférieure du barreau semi-conducteur inférieur et d'une troisième région semi-conductrice supérieure du barreau semi-conducteur supérieur,
- un quatrième groupe de grilles superposées juxtaposé audit deuxième groupe de grilles, le quatrième groupe de grilles superposées comprenant une quatrième grille inférieure et une quatrième grille supérieure superposée à, et séparée de la quatrième grille inférieure par une zone d'isolation, la quatrième grille inférieure et la quatrième grille supérieure étant disposées en regard respectivement d'une quatrième région semi-conductrice inférieure du barreau semi-conducteur inférieur et d'une quatrième région semi-conductrice supérieure du barreau semi-conducteur supérieur.

Ainsi, des rangées superposées de boites quantiques peuvent être avantageusement mise en oeuvre, chaque rangée étant contrôlée par un ensemble de grilles juxtaposées et s'étendant typiquement orthogonalement aux barreaux semi-conducteurs.

Selon une possibilité de mise en oeuvre, entre grilles voisines ou juxtaposées, et en particulier entre le premier groupe de grilles et ledit troisième groupe de grilles: - au moins une électrode d'échange ou des électrodes d'échanges superposées et séparées l'une de l'autre par au moins une couche de séparation isolante peuvent être prévues. Cela permet de réaliser un échange de charges entre boites quantiques. En variante, entre grilles voisines ou juxtaposées, et en particulier entre le premier groupe de grilles et ledit troisième groupe de grilles on peut prévoir une zone de matériau isolant.

Selon un mode de réalisation particulier du dispositif, celui-ci peut être pourvu en outre d'un bloc semi-conducteur dopé formant un premier réservoir de charges, le bloc semi-conducteur dopé étant agencé à une première extrémité du barreau semi-conducteur supérieur et du premier barreau semi-conducteur inférieur. Le dispositif peut avantageusement comprendre un autre bloc semi-conducteur dopé, formant un deuxième réservoir de charges, l'autre bloc semi-conducteur dopé étant agencé à une deuxième extrémité du barreau semi-conducteur supérieur et du barreau semi-conducteur inférieur.

Selon un mise en oeuvre possible du dispositif quantique, ce dernier peut être pourvu d'une région diélectrique agencée entre le premier groupe de grilles superposées, et le deuxième groupe de grilles superposées cette région diélectrique encapsulant les barreaux semi-conducteurs superposés.

De préférence, la zone d'isolation séparant la première grille supérieure et la première grille inférieure est en contact direct à la fois avec une face supérieure de la première grille inférieure et avec une face inférieure de la première grille supérieure et est uniquement constituée de matériau diélectrique et dans lequel la zone d'isolation séparant la deuxième grille supérieure et la deuxième grille inférieure est en contact direct à la fois avec une face supérieure de la deuxième grille inférieure et avec une face inférieure de la deuxième grille supérieure et est uniquement constituée de matériau diélectrique.

Avantageusement, la région diélectrique comporte, dans un premier plan orthogonal à un plan principal du substrat et passant entre le premier groupe de grilles et l'ensemble de barreaux semi-conducteurs superposées, une première portion diélectrique uniquement constituée de matériau diélectrique, la première portion diélectrique s'étendant contre et en contact d'une face latérale de la première grille supérieure et contre et en contact d'une face latérale de la première grille inférieure, la première portion diélectrique comportant une extrémité située dans le prolongement d'une face inférieure de la première grille inférieure, et une autre extrémité située dans le prolongement d'une face supérieure de la première grille supérieure.

Le dispositif quantique s'adapte tout particulièrement à une détection par réflectométrie. Ainsi, les grilles inférieure et supérieure dudit deuxième groupe de grilles et/ou du premier groupe sont couplées ou aptes à être couplées à un circuit de mesure par réflectométrie, ledit circuit étant en particulier configuré pour :
- émettre un signal RF à destination de la deuxième grille inférieure ou de la deuxième grille supérieure ;
- détecter une variation d'impédance consécutive à la réception d'un signal réfléchi par ladite deuxième région semi-conductrice du barreau semi-conducteur inférieur ou par ladite deuxième région semi-conductrice supérieure du barreau semi-conducteur consécutivement à l'émission dudit signal RF.

Selon une première possibilité de mise en oeuvre, le barreau semi-conducteur inférieur et le barreau semi-conducteur supérieur ont une largeur W1 inférieure à une largeur prédéterminée, la deuxième grille inférieure et la deuxième grille supérieure étant configurées pour contrôler respectivement, le potentiel chimique de la première boite quantique et le potentiel chimique de la deuxième boite quantique. Ainsi, on peut prévoir une paire de grille disposées latéralement de part et d'autre d'une boite quantique pour permettre de contrôler cette boite.

En variante, et selon une deuxième possibilité de mise en oeuvre, le barreau semi-conducteur inférieur et le barreau semi-conducteur supérieur ont une largeur W1 supérieure à une largeur prédéterminée, la deuxième grille inférieure et la deuxième grille supérieure étant configurées pour contrôler respectivement, le potentiel chimique d'une troisième boite quantique formée dans ladite deuxième région du barreau inférieur, le potentiel chimique d'une quatrième boite quantique formée dans ladite deuxième région du barreau supérieur.

Selon un mode de réalisation particulier, les grilles desdits groupes de grilles s'étendent orthogonalement auxdits barreaux semi-conducteurs superposés et sont disposées contre des zones latérales des barreaux.

Avantageusement, dans un plan orthogonal à un plan principal du substrat et passant par lesdits barreaux semi-conducteurs superposés, le dispositif est dépourvu d'électrode ou de grille. Le dispositif ne comporte ici donc pas d'électrode de contrôle ou de lecture des boites quantiques ou de grille au-dessus de la structure renfermant ces boites quantiques autrement dit de l'ensemble des barreaux.

On réalise ici avantageusement un contrôle uniquement latéral des barreaux dans lesquels les boites quantiques sont prévues.

Avantageusement :
- la première grille supérieure et la deuxième grille supérieure sont des grilles distinctes et électriquement indépendantes l'une de l'autre de sorte que la première grille supérieure et la deuxième grille supérieure peuvent être mise à des potentiels respectifs différents,
   et/ou
- la première grille inférieure et la deuxième grille inférieure sont des grilles distinctes et électriquement indépendantes l'une de l'autre de sorte que la première grille inférieure et la deuxième grille inférieure peuvent être mise à des potentiels respectifs différents.

Selon un autre aspect, la présente invention concerne un procédé de fabrication d'un dispositif quantique tel que défini plus haut.

Ainsi, selon une possibilité de mise en oeuvre ce procédé peut comprendre des étapes de :
- réalisation sur ledit substrat d'une structure formée d'un empilement de barreaux semi-conducteurs formé d'une alternance de barreaux à base d'un premier matériau, et de barreaux à base d'un deuxième matériau, le deuxième matériau étant semi-conducteur, puis,
- formation de motifs de grille de part et d'autre et contre ladite structure d'empilement, puis,
- libération dans ladite structure des barreaux à base du deuxième matériau par retrait sélectif des barreaux à base du premier matériau.

Avantageusement, la libération des barreaux à base du deuxième matériau conduit à libérer un espace entre lesdits motifs de grilles et autour des barreaux à base du deuxième matériau, le procédé comprenant en outre : une étape de remplissage dudit espace à l'aide d'au moins un matériau diélectrique.

Selon une possibilité de mise en oeuvre, le procédé peut comprendre en outre, préalablement à la formation des motifs de grille de part et d'autre et contre ladite structure, des étapes de :
- gravure partielle des barreaux à base du deuxième matériau par gravure sélective par rapport au premier matériau de sorte à former des renfoncements de part et d'autre de flancs latéraux de ladite structure, puis
- formation de bouchons diélectriques dans lesdits renfoncements.

Selon une mise en oeuvre particulière, le procédé peut comprendre en outre, après formation de ladite structure et préalablement à la libération dans ladite structure des barreaux à base du deuxième matériau, une formation de réservoirs de charges à des extrémités de ladite structure, la formation des réservoirs de charges comprenant:
- réaliser une gravure sélective partielle du premier matériau vis-à-vis du deuxième matériau afin de créer des évidements au niveau desdites extrémités de ladite structure d'empilement,
- combler lesdits évidements par un matériau isolant afin de former des bouchons isolants dans lesdites évidements,
- réaliser une épitaxie de matériau semi-conducteur à partir d'extrémités dévoilées des barreaux à base du deuxième matériau, tandis que les barreaux à base du premier matériau sont protégés par les bouchons isolants.

De manière avantageuse, les motifs de grille de part et d'autre et contre ladite structure sont formés d'un matériau de grille, le procédé comprenant en outre, après libération des barreaux à base du deuxième matériau, des étapes de :
- formation d'une encapsulation isolante entre et autour des motifs de grille,
- retrait partiel dudit matériau de grille de sorte à conserver un bloc inférieur de matériau de grille et libérer des cavités au-dessus de ce bloc inférieur de matériau de grille et entourées par l'encapsulation,
- remplir les cavités d'au moins une couche isolante de sorte à former une zone d'isolation sur le bloc inférieur de matériau de grille puis,
- remplir les cavités d'au moins une couche de matériau de grille, de sorte à former un bloc supérieur de matériau de grille sur la zone d'isolation.

Selon une possibilité de mise en oeuvre, après la formation des motifs de grille et avant formation de l'encapsulation, le procédé peut comprendre en outre :
- formation d'un espaceur isolant réparti de manière conforme sur les motifs de grilles et entre les motifs de grille et agencé sur une zone centrale de ladite structure d'empilement.

Avantageusement, le procédé peut comprendre en outre des étapes de :
- retrait de l'encapsulation isolante entre les motifs de grille ou entre les blocs de grille, de sorte libérer une ou plusieurs espaces,
- formation de grilles d'échange dans le ou les espaces.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1A, la figure 1B et la figure 28 illustrent un exemple de dispositif quantique suivant l'invention à plusieurs niveaux de barreaux semi-conducteurs superposés et, respectivement une première paire de grille superposées et une deuxième paire de grille superposées réparties le long de barreaux semi-conducteurs.
La figure 2 illustre un exemple de dispositif quantique comportant une superposition des barreaux semi-conducteurs et des paires de grilles superposées le long des barreaux, les paires étant ici isolées entre elles.
La figure 3 illustre un exemple de réalisation du dispositif quantique avec des réservoirs de charge aux extrémités des barreaux.
La figure 4 illustre un exemple de dispositif quantique comportant une superposition des barreaux semi-conducteurs et des paires de grilles superposées le long des barreaux, une ou plusieurs grilles d'échanges étant ici prévues entre chaque paire.
La figure 5, la Figure 6A, la Figure 6B illustrent un exemple de réalisation d'une structure semi-conductrice de zone active à barreaux semi-conducteurs empilés pour former un dispositif quantique.
Les figures 7A, 7B, 8A et 8B illustrent un exemple de réalisation de retrait latéral de certains barreaux semi-conducteurs de la structure pour former des renfoncements et pouvoir réaliser des bouchons diélectriques dans ces renfoncements.
Les figure 9, 10 et 11 illustrent un exemple de réalisation de motifs de grille.
Les figures 12, 13 et 14 illustrent un exemple de réalisation de réservoirs de charges.
La figure 15 illustre un exemple de réalisation d'une encapsulation isolante entre et autour des motifs de grilles.
Les figures 16 et 17 illustrent un exemple de retrait sélectif de barreaux à base d'un premier matériau pour libérer des barreaux semi-conducteurs destinés à accueillir chacun typiquement une rangée de boites quantiques.
Les figures 18 et 19 illustrent un exemple de réalisation d'une région diélectrique entre les motifs de grille et autour des barreaux semi-conducteurs.
Les figure 20 à 23 illustrent un exemple de réalisation particulier de grilles superposées selon un procédé avec grille de remplacement.
La figure 24 sert à illustrer des régions isolantes dans un espace inter-grilles voisines ou adjacentes.
Les figures 25, 26 et 27 illustrent une variante de réalisation avec la mise en oeuvre de grilles d'échange dans un espace inter-grilles.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « dessus », « dessous », « inférieur », « supérieur », « juxtaposé », « superposé » s'appliquent en considérant que la structure est orientée de la façon illustrée sur les figures.

### EXPOSÉ DÉTAILLÉ DE MODES DE RÉALISATION PARTICULIERS

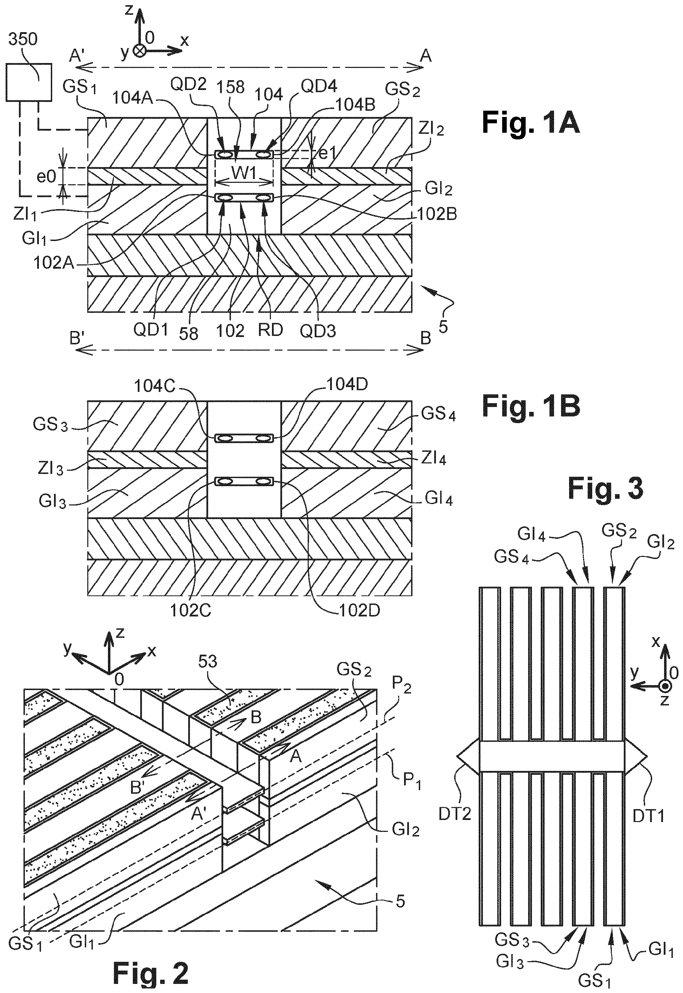

On se réfère tout d'abord aux figures 1A, 1B, 2, 3 qui donnent un exemple de réalisation d'un dispositif quantique (respectivement illustré selon une première vue en coupe transversale A'A, selon une deuxième vue en coupe transversale B'B, selon une vue partielle en perspective, et selon une vue de dessus).

Le dispositif est agencé sur un substrat 5 qui peut être en particulier de type semi-conducteur sur isolant, par exemple de type SOI (SOI pour « Silicon On Insulator » ou silicium sur isolant) ou SiGeOI (pour « Silicon Germanium On Insulator » ou Silicium Germanium sur isolant) ou bien de type massif (« bulk » selon la terminologie anglosaxonne), par exemple en silicium.

Le dispositif comporte ici des boites quantiques QD1, QD2, QD3, QD4 formées dans des régions semi-conductrices de barreaux semi-conducteurs superposées 102, 104 et par exemple en silicium, en particulier du Si²⁸, ou en germanium. Par « barreau » on entend une couche ou une bande comprenant au moins un matériau semi-conducteur.

Par « superposés » on entend ici que les barreaux sont disposés l'un au-dessus de l'autre, un barreau semi-conducteur 104 dit « supérieur » de l'ensemble étant disposé ici au-dessus d'un barreau semi-conducteur 102 dit « inférieur » sans être en contact avec ce dernier.

Les barreaux semi-conducteurs 102, 104, ont une forme qui peut être avantageusement parallélépipédique ou sensiblement parallélépipédique, et s'étendent principalement dans une direction dite « première direction » qui est parallèle au plan principal du substrat 5 (i.e. un plan défini tout au long de la description comme un plan passant par le substrat 5 et qui est parallèle au plan [0;x;y] d'un repère orthogonal [0 ;x ;y ;°z]).

Dans l'exemple de réalisation particulier illustré, les barreaux semi-conducteurs 102, 104 ont, une largeur W1 supérieure à leur épaisseur e1 en particulier de sorte à leur conférer une allure plate ou de bande.

Les barreaux semi-conducteurs 102, 104 peuvent être ainsi prévus avec une largeur W1 (i.e. dimension mesurée parallèlement à l'axe x du repère orthogonal [0 ;x ;y ;°z] donné sur la figure 1A) comprise par exemple entre 20nm et 100nm, avantageusement entre 40nm et 80nm. L'épaisseur e1 (i.e. dimension mesurée parallèlement à l'axe z du repère orthogonal [0 ;x ;y ;°z]) des barreaux semi-conducteurs 102A, 102B peut quant à elle comprise par exemple entre 5nm et 20, avantageusement entre 10nm et 15nm

Comme cela est visible sur les figures 1A, 1B, les barreaux 102, 104 sont typiquement entourés d'au moins un matériau diélectrique 58, par exemple choisi parmi l'un des matériaux suivants : SiO₂, SiN, HfO₂. Une zone isolante 158 est ainsi prévue entre les barreaux 102, 104 afin de préférence d'empêcher un couplage électrostatique entre barreaux 102, 104.

Le dispositif quantique est pourvu également de différentes grilles superposées GI1, GS1, GI2, GS2, GI3, GS3, GI4, GS4 de forme oblongue, avantageusement parallélépipédique ou sensiblement parallélépipédique, et qui s'étendent principalement dans une deuxième direction qui est parallèle au plan principal du substrat 5 et orthogonal à la première direction. Chaque grille GI1, GS1, GI2, GS2 peut être formée d'un bloc conducteur ou semi-conducteur en matériau 22 de grille, par exemple du polysilicium, contre une couche diélectrique de grille disposée entre le bloc de grille et les barreaux semi-conducteurs. Selon une possibilité de mise en oeuvre, cette couche diélectrique de grille peut être à base du même matériau diélectrique 58 que celui de la zone isolante 158.

Dans cet exemple de réalisation, on a avantageusement un alignement des grilles GI1, GI2, GI3, GI4 inférieures et du bloc semi-conducteur inférieure 102 dans un même plan P1 et un alignement des grilles GS1, GS2, GS3, GS4 supérieures et du bloc semi-conducteur supérieur 104 dans un même plan P2 supérieur distinct du plan P1, les plans P1 et P2 étant typiquement des plans parallèles ou sensiblement parallèles au plan principal du substrat 5.

Le fonctionnement du dispositif repose sur un couplage capacitif entre chaque boite quantique QD1 (respectivement QD2, QD3, QD4) et une grille associée GI1 (respectivement GS1, GI2, GS2) de contrôle agencée en regard ou en face de cette boite. Dans cet exemple, du fait d'une largeur W1 suffisante de chacun des barreaux semi-conducteurs 102, 104, typiquement avec W1 supérieure à 40 nm, chaque barreau 102 (resp. 104) peut être, dans une vue en coupe (la coupe étant dans une direction orthogonale à celle des barreaux 102, 104 et typiquement parallèle à celle de grilles (autrement dit une direction parallèle à l'axe x)), être destiné à accueillir deux boites quantiques QD1, QD3 (resp. QD2, QD4). Selon une variante de réalisation, chaque barreau 102, 104 est destiné à accueillir, dans une vue en coupe, une seule boite quantique. Dans ce cas, la largeur W1 de chacun des barreaux semi-conducteurs 102, 104 est typiquement de 20nm. De manière générale, la largeur W1 de chacun des barreaux semi-conducteurs 102, 104 est adaptée en fonction du nombre de boites quantiques souhaité.

Un premier groupe de grilles GI1, GS1 superposées avec une première grille dite « inférieure » GI1 est prévue pour le contrôle respectivement d'une première région semi-conductrice 102A du barreau semi-conducteur inférieure 102 dans laquelle la boite quantique QD1 est formée tandis qu'une première grille dite « supérieure » GS1 est prévue pour le contrôle de la première région semi-conductrice supérieure 104A du barreau semi-conducteur supérieur 104 et dans laquelle la boite quantique QD2 est formée. La grille GI1 contrôle, en fonction d'un potentiel électrostatique qui lui est appliqué, le potentiel chimique de la première boite quantique QD1, tandis que la grille GS1, indépendante de la grille de GI1 contrôle en fonction d'un potentiel électrostatique qui lui est appliqué, le potentiel chimique de la deuxième boite quantique QD2.

La première grille supérieure GS1 est superposée à, et séparée de la première grille inférieure GI1 par le biais d'une première zone d'isolation ZI1. Cette première zone d'isolation ZI1 des grilles inférieure GI1 et supérieure GS1 entre elles est typiquement en matériau isolant et de préférence d'épaisseur eo suffisante pour isoler électriquement les grilles GI1, GS1 l'une de l'autre. Par exemple, la première zone d'isolation ZI1 est formée à base de SiO₂ et a une épaisseur eo qui peut être comprise par exemple entre 5 nm et 20 nm. Dans l'exemple illustré, la première zone d'isolation ZI1 est en contact avec la grille inférieure GI1 et la grille supérieure GS1 et s'étend de la grille inférieure GI1 à la grille supérieure GS1 de sorte que l'épaisseur eo de la première zone d'isolation ZI1 correspond à une distance séparant la grille inférieure GI1 et la grille supérieure GS1 mesurée dans une direction orthogonale à un plan principal du substrat 5.

Pour permettre de réaliser un contrôle des boites quantiques QD3, QD4 on prévoit typiquement un deuxième groupe de grilles GI2, GS2.

Une grille GI2 du deuxième groupe peut être ainsi prévue en regard d'une deuxième région semi-conductrice 102B du barreau semi-conducteur inférieure 102 dans laquelle la boite quantique QD3 est formée tandis qu'une grille GS2 indépendante de la grille GI2 peut être disposée en regard d'une région semi-conductrice 104B du barreau semi-conducteur supérieur 104 et dans laquelle la boite quantique QD4 est formée. La grille GI2 contrôle, en fonction d'un potentiel électrostatique qui lui est appliqué, le potentiel chimique de la troisième boite quantique QD3, tandis que la grille GS2 contrôle, en fonction d'un potentiel électrostatique qui lui est appliqué, le potentiel chimique de la quatrième boite quantique QD4. Une deuxième zone d'isolation ZI2, par exemple également à base de SiO₂ et d'épaisseur eo est également prévue entre les grilles inférieure GI2 et supérieure GS2 du deuxième groupe.

Dans l'exemple de réalisation illustré sur la figure 1A, une région diélectrique RD est agencée entre le premier groupe de grilles GI1, GS1, et le deuxième groupe de grilles GI2, GS2 et encapsule l'ensemble de barreaux semi-conducteurs superposés 102, 104.

Comme on peut le voir sur les figures 1B, 2 et 3 une autre grille inférieure GI3 peut être prévue pour contrôler une autre boite quantique d'une même rangée inférieure que la première boite quantique QD1 et formée dans le barreau inférieur 102, tandis qu'une autre grille supérieure GS3 peut être prévue pour contrôler une boite quantique d'une même rangée supérieure que la deuxième boite quantique QD2 et formée dans le barreau supérieur 104. La grille inférieure GI3 et la grille supérieure GS3 sont ainsi disposées en regard, respectivement d'une région semi-conductrice inférieure 102C du barreau semi-conducteur inférieur 102 et d'une région semi-conductrice supérieure 104C du barreau semi-conducteur 104 supérieur. La grille inférieure GI3 est ici également séparée de la grille supérieure GS3 superposée à, et séparée de la troisième grille inférieure par une zone d'isolation ZI3.

Une grille inférieure GI4 peut être prévue pour contrôler une boite quantique d'une même rangée inférieure que la troisième boite quantique QD3, tandis qu'une autre grille supérieure GS4 peut être prévue pour contrôler une boite quantique d'une même rangée supérieure que la quatrième boite quantique QD4. Ainsi, un groupe de grilles GI4, GS4 superposées comprend une grille inférieure GI4 et une grille supérieure GS4 superposée à, et séparée de la quatrième grille inférieure par une zone d'isolation ZI4. La grille inférieure GI4 et la grille supérieure GS4 sont disposées en regard respectivement d'une région semi-conductrice inférieure 102D du barreau semi-conducteur inférieur 102 et d'une quatrième région semi-conductrice supérieure 104D du barreau semi-conducteur supérieur 104.

Ainsi, le dispositif quantique est ici avantageusement pourvu d'une pluralité de grilles inférieures GI1, GI3 d'un premier côté du barreau semi-conducteur inférieur 102 pour contrôler une première rangée de boites quantiques. Le dispositif peut être également doté d'une pluralité de grilles inférieures GI2, GI4 disposées d'un côté opposé au premier coté du barreau semi-conducteur inférieur 102 pour contrôler une deuxième rangée de boites quantiques opposée à la première rangée.

De même, le dispositif peut être pourvu d'une pluralité de grilles supérieures GS1, GS3 d'un premier côté du barreau semi-conducteur supérieur 104 pour contrôler une troisième rangée de boites quantiques ainsi qu'une pluralité de grilles supérieures GS2, GS4 disposées d'un côté opposé au premier coté du barreau semi-conducteur supérieur 104 pour contrôler une quatrième rangée de boites quantiques opposée à la troisième rangée.

Les boites quantiques QD1, QD2, QD3, QD4 assurent chacune le confinement d'au moins une charge élémentaire (électron(s) ou trou(s)). De préférence, chaque boite quantique QD1, QD2, QD3, QD4 comporte ici une seule charge élémentaire. Le spin de cette charge, en particulier un électron, permet de coder l'information quantique. Dans ce cas, les qubits associés aux boites quantiques QD1, QD2, QD3, QD4 sont des qubit de spin.

Pour permettre de détecter un état quantique également appelé « état de charge » des boites quantique QD1, QD2, QD3, QD4 un dispositif de détection par réflectométrie peut être en particulier prévu.

L'état de d'une boite quantique QD1 (resp. QD2, QD3, QD4) peut être lu en couplant un circuit 350 de réflectométrie à la grille GI1 (resp. GS2, GI2, GS2) située dans son voisinage immédiat et en face ou en regard de cette boite QD1.

La détection de l'état de charge d'une boite quantique QD1 peut être ici mise en oeuvre en appliquant un signal S_{E} RF sur la grille GI1 et en recevant un signal S_{R} RF réfléchi consécutif à l'émission du signal S_{E} RF. Le signal S_{E} RF est typiquement un signal haute fréquence (par exemple comprise entre 100 MHz et 1 GHz) envoyé sur la région 104A. Le signal RF réfléchi par cette région 104A est ensuite démodulé par le circuit 350. de réflectométrie. Une inductance 352 est utilisée afin de créer un résonateur LC composé de cette inductance 352 et qui dépend d'une capacité quantique Cq formée par la boite quantique BQ1 et la grille GI1. Lorsque la valeur de Cq varie, la phase et l'amplitude du signal réfléchi varient, ce qui peut être détecté par des moyens de mesure. Il est ainsi possible de connaître l'état relatif de charge de la boîte quantique QD1 du qubit destiné à être lu.

Dans l'exemple de réalisation particulier illustré sur la figure 2, les espaces inter-grilles sont remplis d'un matériau isolant 53. Ainsi, la grille GI1 est ici isolée de la grille GI3 qui contrôle une boite quantique de la même rangée de boites quantiques que la grille GI1. De même les grilles supérieures adjacentes GS1 et GS3 sont ici isolées l'une de l'autre, par le biais d'une zone en matériau isolant 53, par exemple du SiO₂.

Comme cela est visible sur la vue de dessus de la figure 3, le dispositif peut être muni également de réservoirs de charges, en particulier de régions dopées DT1 et DT2 aux extrémités des barreaux inférieur et supérieur 102, 104. Ces régions dopées DT1, DT2 peuvent être sous forme de blocs, typiquement en matériau semi-conducteur dopé, par exemple du silicium dopé au Phosphore ou du silicium germanium dopé au Bore. Dans l'exemple de réalisation particulier illustré, chaque bloc formant région dopée DT1, DT2 est relié à une extrémité de l'ensemble des barreaux semi-conducteurs 102, 104 (les barreaux n'étant pas visible sur la figure 3).

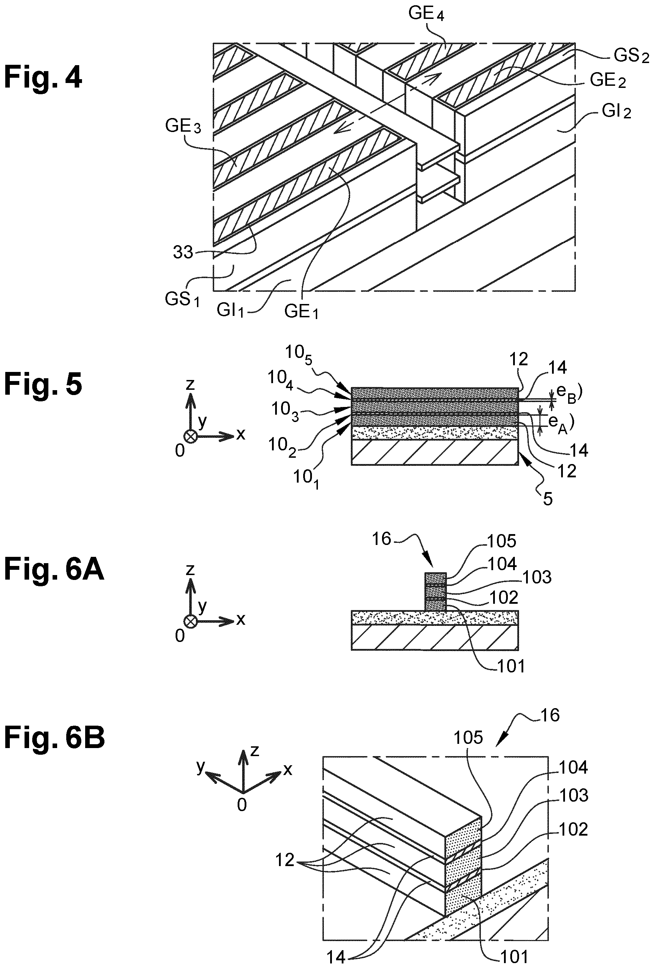

Selon une variante de l'exemple de réalisation illustré sur la figure 2 des électrodes d'échange GE1, GE2, GE3, GE4 également appelées « grilles d'échange » peuvent être prévues dans des espaces inter-grilles. Dans l'exemple de réalisation particulier de la figure 4, une seule électrode d'échange dans un même espace inter-grille.

Les électrodes d'échange GE1, GE2, GE3, GE4 s'étendent principalement dans une direction parallèle à celle dans laquelle les grilles GI1, GS1, GI3, GS3 s'étendent et qui est de préférence orthogonale à la première direction autrement dit à la direction dans laquelle les barreaux semi-conducteur d'accueil 102, 104 des boites quantiques s'étendent. Chaque électrode d'échange est typiquement séparée des grilles adjacentes par le biais d'une couche isolante d'espaceur 33.

Les électrodes d'échanges permettent de réaliser des échanges de charges entre boites quantiques voisines, ou entre ilots de détection voisins, et réparti(e)s le long d'un même barreau semi-conducteur. Ainsi une électrode d'échange peut permettre un échange de charges entre une première région semi-conductrice inférieure 102A contrôlée par une grille GI1 et une autre région semi-conductrice inférieure 102C contrôlée par une grille GI3 adjacente de la grille GI1 et située sur un même barreau semi-conducteur 102 que la première région semi-conductrice inférieure 102A.

Un agencement d'électrodes d'échange semblable à celui des grilles GS3, GI3 ou GS1, GI1 peut être prévu de sorte qu'une électrode d'échange supérieure est disposée au-dessus d'une électrode d'échange inférieure et isolée de cette électrode d'échange inférieure par la couche isolante une couche de séparation isolante.

La mise en oeuvre d'électrodes d'échange est optionnelle, en particulier lorsque le pas Δ de répartition des grilles (« pitch selon la terminologie anglo-saxonne ») est faible et par exemple inférieur à 40 nm. Dans ce cas, ce sont certaines des grilles qui peuvent-être utilisées pour contrôler l'échange entre des boites quantiques ou ilots de détection adjacents d'une même barreau semi-conducteur.

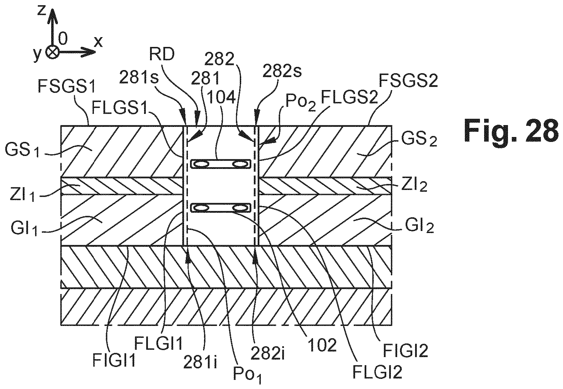

Un agencement particulier de la région diélectrique RD d'encapsulation des barreaux est donné sur la figure 28 (qui reproduit la même structure que la figure 1A mais sans le dispositif de réflectométrie 350).

Dans un premier plan Po1 orthogonal à un plan principal du substrat et passant entre le premier groupe de grilles GI1, GS1 et l'ensemble de barreaux semi-conducteurs superposés 102, 104, une première portion diélectrique 281 de la région diélectrique RD est uniquement constituée de matériau diélectrique. Cette première portion diélectrique 281 s'étend contre et en contact d'une face latérale FLGS1 de la première grille supérieure GS1 et contre et en contact d'une face latérale de la première grille inférieure FLGI1. La première portion diélectrique 281 comporte une extrémité inférieure 281i située dans le prolongement d'une face inférieure FIGI1 de la première grille inférieure GI1 de la première grille inférieure GI1 et une extrémité supérieure 281s située dans le prolongement d'une face supérieure FSGS1 de la première grille supérieure GS1. Dans un deuxième plan Po2 orthogonal à un plan principal du substrat et passant entre le deuxième groupe de grilles GI2, GS2 et l'ensemble de barreaux semi-conducteurs superposés 102, 104, une deuxième portion diélectrique 282 de la région diélectrique RD est uniquement constituée de matériau diélectrique. Cette deuxième portion diélectrique 282 s'étend contre et en contact d'une face latérale FLGS2 de la deuxième grille supérieure GS2 et contre et en contact d'une face latérale de la deuxième grille inférieure FLGI2. La deuxième portion diélectrique 282 comporte une extrémité inférieure 282i située dans le prolongement d'une face inférieure FLGI2 de la deuxième grille inférieure GI2 et une extrémité supérieure 282s située dans le prolongement d'une face supérieure FSGS2 de la deuxième grille supérieure GS2.

Dans l'un ou l'autre des exemples de réalisation qui viennent d'être donnés, le dispositif comprend deux niveaux ou étages de boites quantiques. Toutefois, le dispositif quantique n'est pas limité à ce nombre et peut intégrer un nombre k (avec k>2) d'étages supérieur. Ainsi, plus généralement, un dispositif quantique tel que mis en oeuvre suivant l'invention peut comprendre un nombre k d'étages de blocs semi-conducteurs superposés supérieur à deux, avec k par exemple compris entre 3 et 10).

En variante de l'un ou l'autre des exemples décrits précédemment, on peut prévoir une seule rangée de boites quantique par barreau semi-conducteur 102, 104.

Dans ce cas, les barreaux semi-conducteurs 102, 104 superposés sont prévus avec une largeur W1 plus faible, et en particulier un rapport e1/W1 de son épaisseur sur sa largeur plus élevé. On peut tout de même conserver une ou plusieurs paires de grilles GI1, GI2 (resp. GS1, GS2) de part et d'autre de chaque barreau 102, 104. Dans ce cas, les grilles GI1, GI2 disposées respectivement en face d'une région 102A située sur une portion latérale du barreau 102 et face d'une autre région 102B située sur une portion latérale opposée du barreau 102 sont associées à une même boite quantique. Les grilles GI1, GI2 peuvent être en particulier connectées l'une à l'autre et prévus pour contrôler le potentiel chimique d'une même boite quantique. Alternativement, les grilles GI1, GI2 de contrôle latéral d'un même barreau inférieur peuvent être indépendantes et ainsi déconnectées l'une à l'autre, une grille étant prévue pour contrôler le potentiel chimique de la boite quantique, l'autre étant dédiée à la mesure et à véhiculer le signal RF de réflectométrie. De même, les grilles GS1, GS2 contrôle latéral d'un même barreau supérieur peuvent être électriquement indépendantes, ce qui signifie qu'elles peuvent être mises à des potentiels différents.

Dans l'un ou l'autre des exemples de dispositifs quantiques décrits précédemment, la superposition de barreaux n'est de préférence contrôlée que latéralement par les groupes de grilles GI1, GI2, GS1, GS2, GI3, GS3, GI4, GS4. De préférence, on ne prévoit pas d'électrode de contrôle située au-dessus des barreaux ou entre ces derniers. Ainsi, dans un plan orthogonal au substrat 5 et passant par les barreaux 102, 105, aucune électrode supplémentaire de contrôle des barreaux n'est de préférence prévue afin d'éviter un phénomène d'écrantage intempestif.

Un dispositif quantique tel que prévu selon l'un ou les modes précédemment décrits peut être mis en oeuvre à l'aide d'un procédé de fabrication microélectronique en couches minces.

On se réfère tout d'abord à la figure 5 qui donne un exemple de structure de départ possible pour la réalisation d'un dispositif quantique suivant l'invention et qui comporte ici un substrat 5, ce substrat 5 pouvant être de type semi-conducteur sur isolant, par exemple SOI, ou de type massif (« bulk ») et par exemple en silicium.

Un empilement de couches formé d'une alternance de couches 10₁, 10₃, 10₅ en un premier matériau 12 et de couches 10₂, 10₄, en un deuxième matériau 14, semi-conducteur, est tout d'abord formé sur le substrat 5.

Les matériaux 12, 14 sont typiquement des matériaux semi-conducteurs différents l'un de l'autre, le premier matériau 12 étant apte à être gravé de manière sélective vis-à-vis du second matériau 14. L'empilement est dans ce cas typiquement réalisé par épitaxies successives. L'exemple de réalisation particulier illustré sur la figure 5 prévoit un nombre impair de couches, en particulier cinq couches, mais le procédé peut être effectué avec un nombre de couches différent et en particulier supérieur.

Les couches 10₁, 10₃, 10₅ à base du premier matériau 12 peuvent être réalisées avantageusement avec une épaisseur e_{A} supérieure à celle des couches 10₂, 10₄, à base du deuxième matériau 14, et qui peut être par exemple plus de deux fois supérieure à celle des couches 10₂, 10₄. Les couches 10₁, 10₃, 10₅ à base du premier matériau 12 peuvent avoir une épaisseur e_{A} comprise par exemple, entre 10 nm et 50 nm, tandis que les couches 10₂, 10₄, ont une épaisseur e_{B} comprise par exemple entre 5 nm et 20 nm. Par exemple, le premier matériau 12 est en silicium, en particulier du Si²⁸, tandis que le deuxième matériau 14 est en Si₁₋ₓGeₓ, avec x > 0, x étant par exemple de l'ordre de 30%. Les couches 10₁, 10₃, 10₅, 10₂, 10₄, peuvent être réalisées par épitaxies successives.

Lorsque la première couche 10₁ est en SiGe, on peut éventuellement former cette couche à partir d'une couche superficielle de silicium d'un substrat SOI par une méthode d'enrichissement en Germanium connue de l'Homme du métier et qui consiste à réaliser une épitaxie de silicium puis effectuer une oxydation afin de faire diffuser le germanium. Une gravure est ensuite réalisée de manière à retirer l'oxyde formé. La couche 10₁ peut être en variante la couche superficielle d'un substrat SiGeOI

Ensuite (figures 6A et 6B), on définit par gravure de l'empilement de couches, une structure 16 de zone active, ici sous forme d'un bloc, typiquement de forme oblongue, par exemple parallélépipédique, et qui s'étend principalement dans une première direction (direction orthogonale au plan de la figure 6A et parallèle à l'axe y du repère orthogonal [0 ;x ;y ;°z]). Cela peut être réalisé par photolithographie et gravure de l'empilement. Une gravure sèche utilisant une chimie fluorocarbonnée et réalisée à travers tandis qu'une partie de l'empilement est protégée par un masque de lithographie (non représenté) peut être pour cela effectuée.

La structure 16 réalisée par gravure à partir des couches 10₁, 10z, 10₃, 10₄, 10₅ est formée d'un empilement de barreaux semi-conducteurs comportant une alternance de barreaux 101, 103, 105 à base du premier matériau 12, et de barreaux 102, 104 à base du deuxième matériau 14.

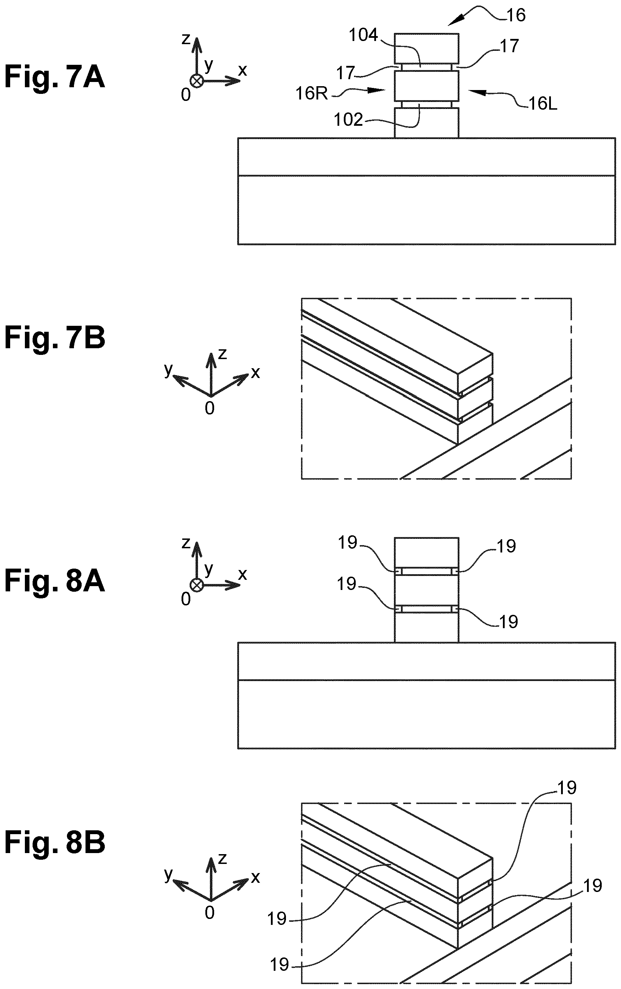

On réalise ensuite une gravure partielle des barreaux 102, 104 à base du deuxième matériau 14 par gravure sélective par rapport au premier matériau 12 de sorte à former des renfoncements 17 latéraux de part et d'autre de flancs latéraux 16L, 16R de la structure 16 d'empilement (figures 7A et 7B). Cette gravure latérale peut être réalisée par gravure chimique humide, par exemple à l'aide d'une solution de NH4OH, ou de TMAH (hydroxyde de tétraméthylammonium) ou de TEAH (hydroxyde de tétraéthylammonium), lorsque l'on grave du Si de manière sélective par rapport à du SiGe. Un retrait de portions latérales des barreaux 102, 104, par exemple d'au moins 5 nm peut être en particulier lorsque ces derniers ont une largeur typiquement comprise entre 40 nm et 80 nm.

Ensuite, on forme des bouchons diélectriques 19 dans les renfoncements 17 latéraux (figures 8A et 8B). Pour cela, on réalise typiquement un dépôt sur la structure 16 d'empilement, avantageusement conforme de matériau diélectrique par exemple du SiN, du SiO₂ ou du HfO₂, selon une épaisseur choisie de sorte à combler les renfoncements 17.

Ce dépôt est suivi d'au moins une gravure, typiquement d'une gravure sèche ou d'une combinaison de gravure sèche et d'une gravure humide du diélectrique déposé précédemment, de manière à retirer ce matériau diélectrique et à ne le conserver que sous forme des bouchons diélectriques 19 contre, et masquant les flancs latéraux des blocs 102, 104 à base du deuxième matériau 14.

On forme ensuite des motifs 25 de grille en matériau 22 de grille de part et d'autre de la structure 16.

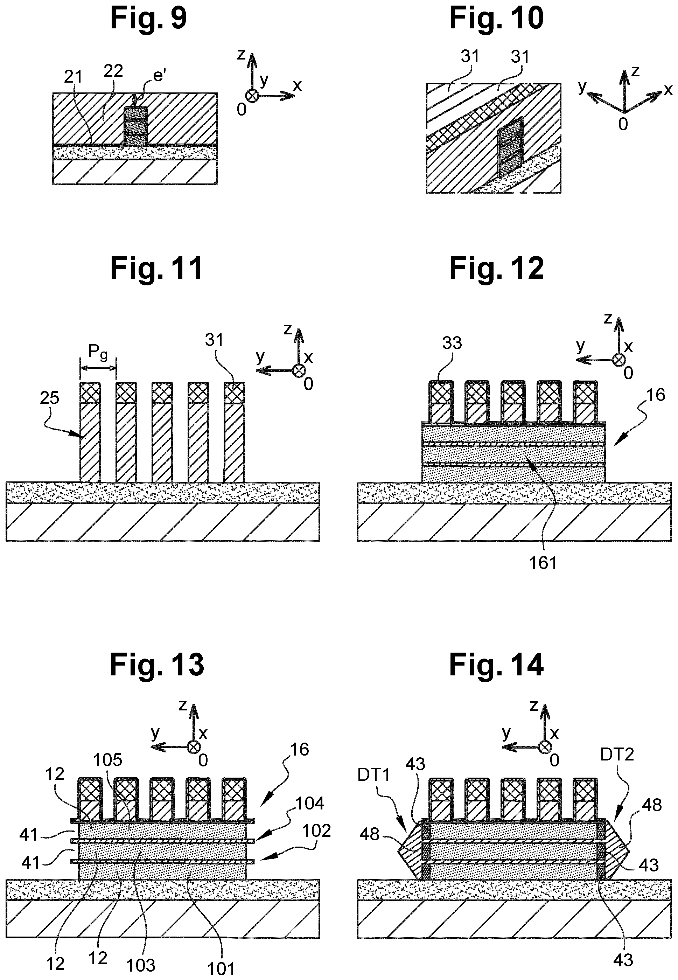

Pour cela, on peut déposer tout d'abord au moins une couche 21 de diélectrique de grille, par exemple d'oxyde de silicium (SiO₂) ou formée d'un empilement d'oxyde de silicium et d'un matériau high-k tel que par exemple du HfO₂. Ce dépôt est suivi de celui d'au moins une couche de matériau 22 de grille, conducteur, tel que du polysilicium dopé (figure 9).

De préférence, après dépôt et une éventuelle planarisation par CMP (« Chemical mechanical polishing ») ou polissage mécanochimique on laisse une épaisseur e' non-nulle et par exemple de l'ordre de 50 nm de matériau conducteur 22 dépasser au-dessus de la structure 16 de zone active.

Des masques durs 31, typiquement diélectriques et par exemple formés d'un empilement de SiN et de SiO₂ sont ensuite réalisés (figure 10).

On effectue ensuite (figure 11 donnant une vue en coupe selon premier plan de coupe parallèle au repère [0 ;y ;°z]) une lithographie et une gravure de l'empilement de grille pour former un réseau de motifs 25 de grilles parallèles et de forme allongée. Les motifs 25 peuvent être par exemple sous forme de blocs parallélépipédique, et s'étendent typiquement orthogonalement aux barreaux de la structure 16.

Les motifs 25 de grille peuvent être répartis selon un pas Pg faible, par exemple de l'ordre de 100 nm, voire plus faible, par exemple de 40 nm, pour former un réseau dense de motifs 25.

Après la formation des motifs 25 de grille, on peut avantageusement former des réservoirs de dopants DT1, DT2 (figures 12 à 14).

Selon une méthode, on dépose tout d'abord de manière conforme une fine couche isolante d'espaceur 33 sur les motifs 25 de grille, par exemple en nitrure de silicium et d'épaisseur qui peut être comprise par exemple entre 5 nm et 10 nm. La fine couche isolante d'espaceur 33 est agencée sur et entre les motifs 25 de grille, par exemple par une technique de type ALD (pour « Atomic Layer Déposition » ou « dépôt de couche atomique ») afin de remplir les espaces inter motifs de grilles sans création de défaut de remplissage.

On effectue ensuite une lithographie de sorte à retirer des portions de la fine couche isolante d'espaceur 33 et prolonger cette gravure dans des parties de la structure 16 de zone active situées autour d'une autre partie 161 à l'aplomb de l'ensemble des motifs 25 de grilles (figure 12 donnant une vue en coupe selon un plan de coupe parallèle au repère [0 ;y ;°z]). Pour effectuer ce retrait, un exemple de procédé comprend la formation d'un empilement lithographique, par exemple un tri-couches formé d'une couche de SOC, d'une couche anti-réflechissante, d'une résine photosensible, que l'on dépose puis l'on insole. L'empilement de lithographie protège les zones où le diélectrique de la fine couche isolante d'espaceur 33 doit être conservé. Une gravure sèche de type fluorocarbonnée peut être prévue pour retirer la fine couche isolante d'espaceur 33 à base de SiN en dehors des zones protégées.

Pour former les réservoirs de dopants en contact avec les extrémités des barreaux 102, 104 semi-conducteurs sans mettre en contact ces réservoirs avec les autres barreaux 101, 103, 105, de la structure, on peut avantageusement réaliser une gravure sélective partielle du premier matériau 12 vis-à-vis du deuxième matériau 14 afin de retirer des portions d'extrémités des barreaux 102, 104 et de créer des évidements 41 (figure 13) au niveau d'extrémités de la structure 16.

Par exemple, lorsque le premier matériau 12 est en SiGe, cette gravure est effectuée par exemple réalisée par gravure chimique humide, ou à l'aide de HCl ou d'un mélange HF:H2O2:CH3COOH. On peut prévoir avantageusement un ratio proche ou égal à 1:1 entre la profondeur gravée et l'épaisseur de la couche gravée. Un retrait par exemple d'au moins 5 nm peut être prévu pour réaliser ces évidements 41. Les évidements 41 sont ensuite comblés par des bouchons isolants 43 encore appelés « espaceurs internes ». Cela peut être réalisé par exemple au moyen d'un dépôt conforme de matériau diélectrique, par exemple de SiN ou SiO₂. Ce dépôt est typiquement suivi d'une gravure sèche ou d'une combinaison de gravure sèche et humide du diélectrique déposé, de manière à former des bouchons isolants 43 bloquant l'accès aux barreaux 101, 103, 105 à base du premier matériau 12.

Une fois les bouchons isolants 43 réalisés, on peut réaliser une épitaxie (figure 14) sélective de matériau semi-conducteur 48 à partir des extrémités dévoilées des barreaux 102, 104, à base du second matériau 14. L'épitaxie peut prévoir un dopage *in situ.* Par exemple des réservoirs de dopants DT1, DT2 en Si:P ou en SiGe:B peuvent être formés par épitaxie à partir d'extrémités des barreaux 102, 104 de silicium. L'épitaxie formée peut suivre ou non des orientations cristallines préférentielles, et les fronts d'épitaxie issus des différentes couches de Si peuvent éventuellement se rejoindre comme dans l'exemple de réalisation représenté sur la figure 13 pour former des blocs ou amas semi-conducteurs.

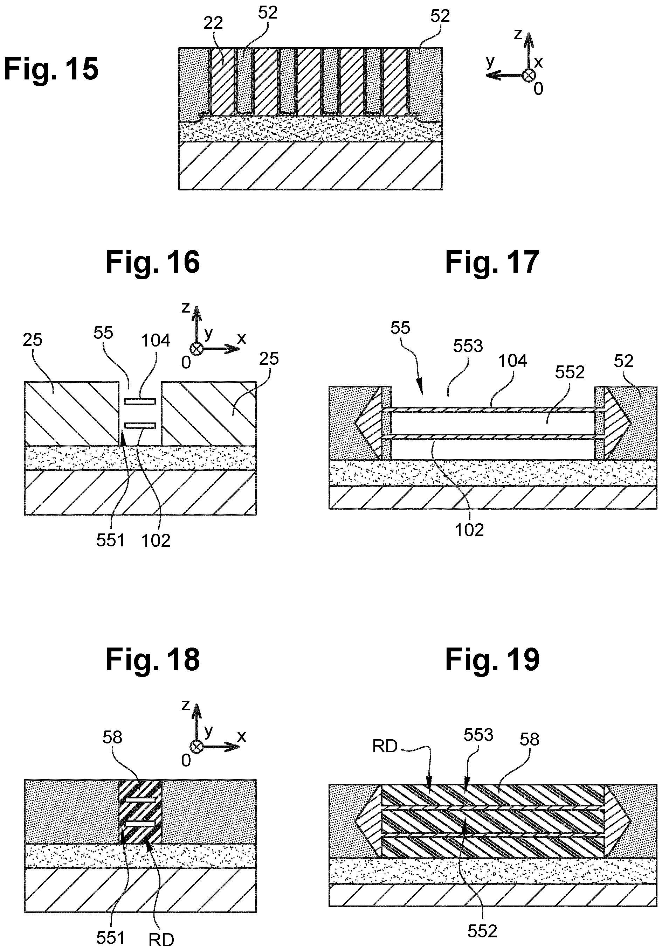

On réalise ensuite une encapsulation 52 isolante autour des motifs de grille. L'encapsulation isolante 52 peut être réalisée par exemple par dépôt d'un matériau de type PMD (pour « Pre Metal Dielectric ») tel que par exemple du SiO₂ sur l'ensemble de la structure 16 suivi d'une étape de planarisation CMP. Cette étape est effectuée de préférence de manière à ce que le front de polissage s'arrête au sommet de la structure 16 de zone active. Cela permet de dévoiler le matériau 22 des motifs de grilles, typiquement en matériau de grille conducteur tel que du polysilicium (figure 15).

La structure finale destinée à accueillir les boites quantiques est ici prévue sous forme de barreaux semi-conducteurs 102, 104 suspendus et superposés, les barreaux 102, 104 étant espacés l'un de l'autre.

Pour cela, on effectue ensuite une libération (figures 16 et 17) dans ladite structure des barreaux semi-conducteurs 102, 104 à base du deuxième matériau 14 en retirant les barreaux à base du premier matériau 12 par gravure sélective vis-à-vis du deuxième matériau 14. Une telle étape est représentée sur les figures 16 et 17. Cette libération s'accompagne typiquement du retrait des bouchons diélectriques 19 agencés le long des barreaux à base du deuxième matériau 14. Cette libération est avantageusement mise en oeuvre à l'aide de plusieurs sous-étapes de gravure, en particulier de gravure humide sélective.

Typiquement, on met en oeuvre un procédé dans lequel, on effectue tout d'abord un retrait couche par couche depuis le haut de la structure 16. On grave ainsi la couche supérieure 105 de premier matériau semi-conducteur 12, puis les bouchons sacrificiels 19 de part et d'autre de la couche 104 de deuxième matériau 14, puis la couche 103 de premier matériau semi-conducteur 12, puis les bouchons 19 de part et d'autre de la couche 102 de deuxième matériau 14, puis la couche supérieure 101 de premier matériau semi-conducteur 12.

Une gravure sélective du SiGe par rapport au Si peut être par exemple effectuée à l'aide de de HCl ou d'un mélange HF:H2O2:CH3COOH. On peut prévoir autant de séquences de gravures que d'étages de barreaux à base du premier matériau 12.

La libération des barreaux 102, 104 à base du deuxième matériau conduit à la formation d'un espace 55, autrement dit d'une cavité, qui s'étend autour et entre les barreaux 102, 104 et est situé entre les motifs 25 de grilles.

Ensuite (figures 18 et 19), on effectue un remplissage de cet espace 55 à l'aide d'au moins un matériau diélectrique 58 par exemple tel que du SiO2, ou du SiN, ou du HfO2 afin de former une région diélectrique RD enrobant les barreaux 102, 104.

Typiquement, on effectue pour cela un dépôt conforme du matériau diélectrique 58 puis une étape de planarisation par exemple par CMP.

Dans un cas où les bouchons diélectriques 19 ont été retirés ou gravés partiellement précédemment lors de l'étape de libération des barreaux semi-conducteurs 102, 104 précédemment décrite, le matériau diélectrique 58 fait office de diélectrique de grille ou forme une épaisseur de diélectrique de grille dans des emplacements 551 situés entre les barreaux semi-conducteurs 102, 104 et les motifs 25 de grille. On remplit également un volume 552 séparant les barreaux semi-conducteurs 102, 104 et une zone 553 autour de l'ensemble des barreaux 102, 104.

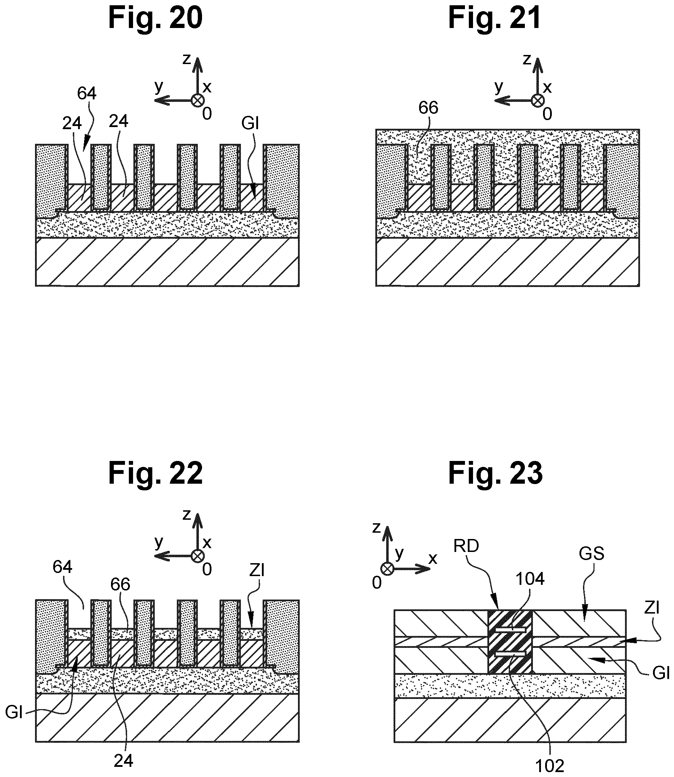

On complète ensuite la formation de grilles superposées. Pour cela, on effectue une gravure partielle du matériau 22 des motifs de grilles (figure 20). Le retrait partiel du matériau 22 de grille est réalisé de sorte à conserver un bloc 24 inférieur de matériau de grille et réaliser des cavités 64 entourées par l'encapsulation 52 et disposées au-dessus de ce bloc inférieur 24 de matériau de grille. Une gravure sèche ou bien une gravure chimique, en particulier une gravure humide à l'aide de TMAH est en particulier mise en oeuvre lorsque le matériau 22 est du polySi.

La gravure est réalisée de sorte à contrôler la hauteur du bloc 24 inférieur de matériau de grille par rapport à celle des couches semi-conductrices de la structure 16 de zone active. On met en oeuvre un retrait partiel de sorte à ce que ce bloc 24 destiné à former des grilles inférieures GI soit en regard que du barreau semi-conducteur inférieur 102.

On remplit ensuite (figure 21) ces cavités 64 d'au moins une couche de matériau isolant 66, par exemple du SiO₂. Ce dépôt est éventuellement suivi d'une planarisation et d'une gravure (figure 22) pour retirer partiellement le matériau isolant 66 déposé. Le matériau isolant 66 sert à former une zone d'isolation ZI permettant d'isoler entre elles les grilles GI d'étage inférieur des grilles GS d'étage supérieur. Une nouvelle couche de matériau conducteur, avantageusement à base du même matériau conducteur 22 que la grille inférieure Gl, par exemple du polysilicium, est ensuite déposée de manière à combler les cavités 64. On effectue ensuite typiquement une planarisation par CMP pour former ainsi des grilles supérieures GS en regard du barreau supérieur 104 (figure 23).

Dans l'exemple de procédé de réalisation qui vient d'être donné, pour la mise en oeuvre des grilles superposées GI, GS, on prévoit des grilles inférieures GI formées à base d'un même matériau 22 que les grilles supérieures GS. Il est en variante toutefois possible de prévoir des matériaux différents entre les grilles inférieures GI d'une part et les grilles supérieures GS d'autre part.

De même, dans l'exemple de réalisation qui vient d'être donné, les grilles formées contre la portion 16R de zone active dédiée par exemple à l'accueil des boites quantiques sont à base d'un même matériau que celles situées contre la portion 16L de zone active qui lui fait face et qui est dédiée par exemple à l'accueil des ilots de détection.

Il est en variante toutefois possible de prévoir des matériaux différents entre d'une part les grilles situées contre la portion 16R et d'autre part les grilles situées contre la portion 16L. Une telle variante peut être réalisée pour obtenir des travaux de sortie et par conséquent des régimes de fonctionnement différents entre par exemple des grilles contrôlant les boites quantiques et des contrôlant grilles contrôlant les ilots de détection. Pour réaliser une telle variante, on peut prévoir d'ajouter une ou plusieurs étapes de lithographie et une ou plusieurs étapes de dépôt supplémentaires.

En variante de l'exemple de procédé de réalisation qui vient d'être donné la mise en oeuvre des grilles superposées GI, GS, qui décrit une approche de type communément appelée « gate-last » (avec grille de remplacement) où l'on effectue un remplacement au moins partiel de motifs de grille par un empilement avec des grilles séparées d'une zone d'isolation, on peut prévoir de réaliser directement des motifs de grilles composés de cet empilement.

Ainsi, selon cette variante de réalisation des grilles, une approche de type appelée « gate-first » (grille en premier) peut être prévue. Dans ce cas, directement après l'étape de formation de la structure 16 de zone active décrite précédemment en lien avec les figures 6A-6B, on peut prévoir la réalisation d'un empilement de couches pour former la grille inférieure, la zone d'isolation, puis la grille supérieure. Les épaisseurs des couches conductrices ou semi-conductrices de matériau(x) de grille et de la couche isolante intercalée sont alors ajustées de préférence en fonction de celles des couches de premier matériau 12 et de deuxième matériau 14 de la structure 16 afin que chaque couche de matériau de grille soit disposée en vis-à-vis et dans un même plan parallèle au plan principal du substrat qu'une couche à base du deuxième matériau semi-conducteur 14 et dans lequel des boites quantiques ou ilots de détection sont prévus.

Dans l'un ou l'autre des exemples de réalisation qui viennent d'être décrits, la prise de contact sur des niveaux de grilles différents ainsi que sur des niveaux de couches semi-conductrices différentes, peut être réalisée par exemple en prévoyant, aux extrémités des structures de grilles ou des portions de zone active, une forme en escalier.

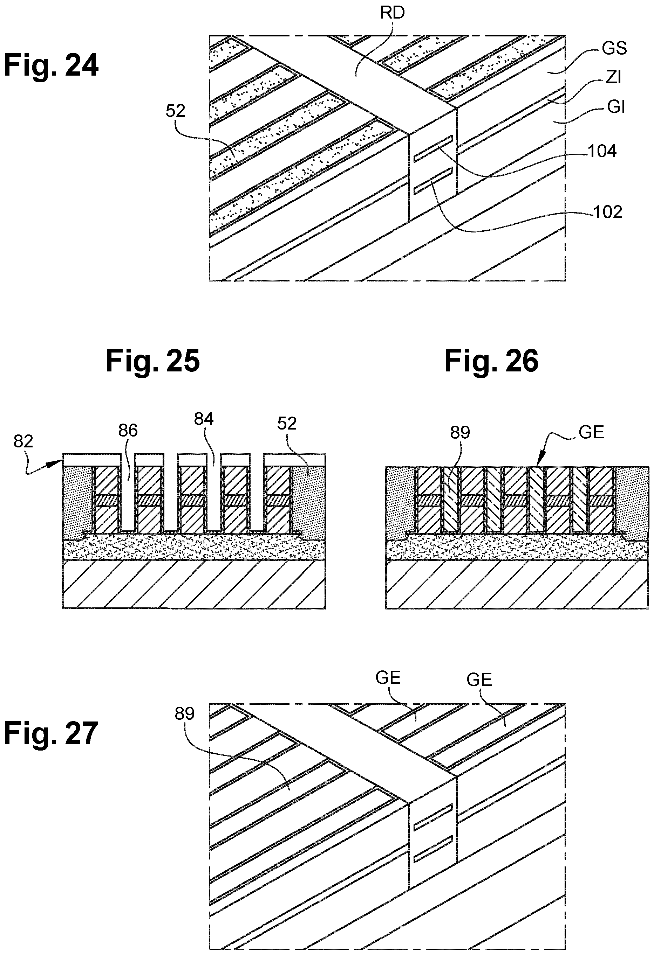

Dans l'exemple de réalisation illustré sur la figure 24, le ou les espaces dits « inter-grilles » entre grilles voisines ou adjacentes réparties le long de barreaux 102, 104 sont remplies de matériau isolant, ici de l'encapsulation 52.

En variante, on peut prévoir de réaliser des électrodes d'échange dans le ou les espaces inter-grilles.

Pour cela, une méthode illustrée sur les figures 25 à 27 consiste à partir d'une structure telle qu'obtenue à l'issue de la réalisation des grilles. On réalise ensuite un masquage 82, typiquement en résine photosensible, dans une zone située au-dessus de l'ensemble blocs de grilles et qui comporte des ouvertures 84 en regard d'espaces inter-grilles (figure 25). On grave ensuite de manière sélective le matériau isolant d'encapsulation 52, par exemple du SiO2, situé dans les espaces inter-grilles sélectivement par rapport à la fine couche d'espaceur 33, par exemple en SiN, afin de former des trous 86. Un procédé de gravure sèche fluoro-carbonnée peut être en particulier utilisé.

Après retrait du masquage 82, un dépôt de matériau conducteur 89, par exemple un empilement de type TiN/W est réalisé pour remplir les trous 414 ainsi définis (figure 26). Ce dépôt est typiquement suivi d'une étape de planarisation CMP. L'arrêt de la planarisation est effectué de préférence lorsque l'on atteint le sommet de la structure de zone active (non visible sur les figures 26 et 27). Dans cet exemple de réalisation on réalise une seule électrode d'échange GE par espace inter-grille.

Toutefois, il est en variante possible de former des grilles d'échange superposées et qui suivent un agencement semblable à celui des électrodes de grilles entre lesquelles ces grilles d'échange sont inter-callées. On peut ainsi former dans chaque espace inter-grille des paires de grilles d'échange superposées et séparées entre elle d'un isolant. Pour cela, on peut suivre un procédé semblable à celui utilisé pour réaliser les grilles et décrit précédemment en liaison avec les figures 11 à 20-22.

## Revendications

1. Dispositif électronique quantique doté d'un substrat (5) et comprenant sur ce substrat :
- un ensemble de barreaux semi-conducteurs (102, 104) superposés comprenant au moins un barreau semi-conducteur inférieur (102) et au moins un barreau semi-conducteur supérieur (104), le barreau semi-conducteur inférieur et le barreau semi-conducteur supérieur (104) étant disposés l'un au-dessus de l'autre,
- un premier groupe de grilles (GI1, GS1) comprenant une première grille inférieure (GI1) et une première grille supérieure (GS1), la première grille supérieure (GS1) étant superposée à la première grille inférieure (GI1) et séparée de la première grille inférieure par une zone d'isolation (ZI1), la première grille inférieure (GI1) étant disposée en regard d'une première région (102A) du barreau semi-conducteur inférieur (102), la première grille inférieure (GI1) étant une grille de contrôle latéral du barreau semi-conducteur inférieur (102) apte à être couplée par couplage capacitif à la première région (102A), de sorte à former une première boite quantique (QD1) dans la première région (102A) du barreau semi-conducteur inférieur (102), la première grille supérieure (GS1) étant disposée en regard d'une première région (104A) du barreau semi-conducteur supérieur (104), la première grille supérieure (GS1) étant une grille de contrôle latéral du barreau semi-conducteur supérieur (104) et étant apte à être couplée par couplage capacitif à la première région (104A) du barreau semi-conducteur supérieur (102) de sorte à former un deuxième boite quantique (QD2) dans la première région (104A) du barreau semi-conducteur supérieur (104),
- un deuxième groupe de grilles (GI2, GS2) comprenant une deuxième grille inférieure (GI2) et une deuxième grille supérieure (GS2), la deuxième grille supérieure (GS2) étant superposée à la deuxième grille inférieure et séparée de la deuxième grille inférieure (GI2) par une zone d'isolation (ZI2), la première grille inférieure (GI2) étant une grille de contrôle latéral du barreau semi-conducteur inférieur (102) disposée en regard de, et apte à être couplée par couplage capacitif à une deuxième région (102B) du barreau semi-conducteur inférieur (102) opposée à la première région (102A) du barreau semi-conducteur inférieur, la deuxième grille supérieure (GS2) étant une grille de contrôle latéral du barreau semi-conducteur supérieur disposée en regard de, et apte à être couplée par couplage capacitif à une deuxième région (104B) du barreau semi-conducteur supérieur (104) opposée à la première région (104A) du barreau semi-conducteur supérieur, ledit ensemble de barreaux semi-conducteurs (102A, 104A) étant disposé entre le premier groupe de grilles (GI1, GS1) et le deuxième groupe de grilles (GI2, GS2), de sorte que dans un premier plan (P1) parallèle à un plan principal du substrat, le barreau semi-conducteur inférieur (102) est agencé entre la première grille inférieure (GI1) et la deuxième grille inférieure (GI2) et dans un deuxième plan (P2) parallèle à un plan principal du substrat, le barreau semi-conducteur supérieur (104) est agencé entre la première grille supérieure (GI1) et la deuxième grille supérieure (GI2).

2. Dispositif électronique quantique selon la revendication 1, comprenant en outre :
- un troisième groupe de grilles superposées (GI3, GS3) juxtaposé audit premier groupe de grilles (GI1, GS1), le troisième groupe de grilles (GI3, GS3) comprenant au moins une troisième grille supérieure (GS3) superposée à une troisième grille inférieure (GI3) la troisième grille supérieure (GS3) étant séparée de la troisième grille inférieure par une zone d'isolation, la troisième grille inférieure (GI3) et la troisième grille supérieure (GS3) étant disposées en regard, respectivement d'une troisième région semi-conductrice inférieure (102C) du barreau semi-conducteur inférieur (102) et d'une troisième région semi-conductrice supérieure (104C) du barreau semi-conducteur supérieur (104),
- un quatrième groupe de grilles superposées (GI4, GS4) juxtaposé audit deuxième groupe de grilles (GI2, GS2), le quatrième groupe de grilles (GI4, GS4) comprenant une quatrième grille supérieure (GS4) superposée à une quatrième grille inférieure (GI4), la quatrième grille supérieure (GS4) étant séparée de la quatrième grille inférieure par une zone d'isolation, la quatrième grille inférieure (GI4) et la quatrième grille supérieure (GS4) étant disposées en regard respectivement d'une quatrième région semi-conductrice inférieure (102D) du barreau semi-conducteur inférieur (102) et d'une quatrième région semi-conductrice supérieure (104D) du barreau semi-conducteur supérieur (104).

3. Dispositif selon la revendication 2, comprenant en outre, entre ledit premier groupe de grilles (GI1, GS1) et ledit troisième groupe de grilles (GI3, GS3) :
- au moins une électrode d'échange (GE) pour réaliser des échanges de charges entre boites quantiques voisines réparti(e)s le long d'un même barreau semi-conducteur parmi le barreau semi-conducteur supérieur (104) et le barreau semi-conducteur inférieur (104) ou,
- des électrodes d'échanges superposées (GE11, GE12) et séparées l'une de l'autre par au moins une couche de séparation isolante (CSI), ou
- une zone d'au moins un matériau isolant (52).

4. Dispositif selon l'une des revendications 1 à 3, comprenant en outre :
- un bloc semi-conducteur dopé, formant un premier réservoir de charges (DT1), le bloc semi-conducteur dopé étant agencé à une première extrémité du barreau semi-conducteur supérieur (104) et du premier barreau semi-conducteur inférieur (102),
- un autre bloc semi-conducteur dopé, formant un deuxième réservoir de charges (DT2), l'autre bloc semi-conducteur dopé étant agencé à une deuxième extrémité du barreau semi-conducteur supérieur (104) et du barreau semi-conducteur inférieur (102).

5. Dispositif selon l'une des revendications 1 à 4, dans lequel une région diélectrique (RD) est agencée entre le premier groupe de grilles (GI1, GS1), et le deuxième groupe de grilles (GI2, GS2) et encapsule l'ensemble de barreaux semi-conducteurs superposés (102, 104).

6. Dispositif selon l'une des revendications précédentes, dans lequel la zone d'isolation (ZI1) séparant la première grille supérieure (GS1) et la première grille inférieure (GI1) est en contact direct à la fois avec une face supérieure de la première grille inférieure et avec une face inférieure de la première grille supérieure et est uniquement constituée de matériau diélectrique et dans lequel la zone d'isolation (ZI2) séparant la deuxième grille supérieure (GS2) et la deuxième grille inférieure (GI2) est en contact direct à la fois avec une face supérieure de la deuxième grille inférieure et avec une face inférieure de la deuxième grille supérieure et est uniquement constituée de matériau diélectrique.

7. Dispositif selon l'une des revendications 1 à 6, dans lequel les grilles inférieure (GI2) et supérieure (GS2) dudit deuxième groupe de grilles et/ou du premier groupe (GI1, GS1) sont couplées à un circuit (350) de mesure par réflectométrie, configuré pour :
- émettre un signal RF à destination de la deuxième grille inférieure ou de la deuxième grille supérieure ;
- détecter une variation d'impédance consécutive à la réception d'un signal réfléchi par ladite deuxième région semi-conductrice du barreau semi-conducteur inférieur ou par ladite deuxième région semi-conductrice supérieure du barreau semi-conducteur consécutivement à l'émission dudit signal RF.

8. Dispositif selon l'une des revendications 1 à 7,
∘ dans lequel le barreau semi-conducteur inférieur et le barreau semi-conducteur supérieur ont une largeur W1 inférieure à une largeur prédéterminée, la deuxième grille inférieure (GI2) et la deuxième grille supérieure (GS2) étant configurées pour contrôler respectivement, le potentiel chimique de la première boite quantique (QD1) et le potentiel chimique de la deuxième boite quantique (QD2) ou,
∘ dans lequel le barreau semi-conducteur inférieur et le barreau semi-conducteur supérieur ont une largeur W1 supérieure à une largeur prédéterminée, la deuxième grille inférieure (GI2) et la deuxième grille supérieure (GS2) étant configurées pour contrôler respectivement, le potentiel chimique d'une troisième boite quantique (QD3) formée dans ladite deuxième région du barreau inférieur, le potentiel chimique d'une quatrième boite quantique (QD4) formée dans ladite deuxième région du barreau supérieur.

9. Dispositif selon l'une des revendications 1 à 8, dans lequel, les grilles desdits groupes de grilles (GI1, GI2,) sont disposées contre des zones latérales des barreaux (102, 104) et dans lequel dans un plan orthogonal à un plan passant par lesdits barreaux semi-conducteurs (102, 104) superposés et dans lequel lesdits barreaux semi-conducteurs (102, 104) superposés sont contenus sur toute leur longueur, le dispositif ne comporte pas d'électrode de contrôle des barreaux ou de grille de contrôle des barreaux.

10. Dispositif selon l'une des revendications 1 à 9,
- la première grille supérieure (GS1) et la deuxième grille supérieure (GS2) étant des grilles distinctes et électriquement indépendantes l'une de l'autre de sorte que la première grille supérieure (GS1) et la deuxième grille supérieure (GS2) peuvent être mises à des potentiels respectifs différents,
et/ou
- la première grille inférieure (GI1) et la deuxième grille inférieure (GI2) étant des grilles distinctes et électriquement indépendantes l'une de l'autre de sorte que la première grille inférieure (GI1) et la deuxième grille inférieure (GI2) peuvent être mises à des potentiels respectifs différents.

11. Procédé de fabrication d'un dispositif quantique selon l'une des revendications précédentes, comprenant des étapes de :
- réalisation sur ledit substrat (10) d'une structure (16) formée d'un empilement de barreaux semi-conducteurs comprenant une alternance de barreaux (101, 103, 105) à base d'un premier matériau (12), et de barreaux (102, 104) à base d'un deuxième matériau, le deuxième matériau étant semi-conducteur, puis,
- formation de motifs (25) de grille de part et d'autre de ladite structure (16), puis,
- retrait sélectif des barreaux (101, 103, 105) à base du premier matériau (12).

12. Procédé selon la revendication 11, comprenant en outre, préalablement à la formation des motifs (25) de grille de part et d'autre de ladite structure (16), des étapes de :
- gravure partielle des barreaux (102, 104) à base du deuxième matériau (14) par gravure sélective par rapport au premier matériau (12) de sorte à former des renfoncements (17) de part et d'autre de flancs latéraux de ladite structure (16), puis
- formation de bouchons diélectriques (19) dans lesdits renfoncements (17).

13. Procédé selon l'une des revendications 11 ou 12, comprenant en outre, après formation de ladite structure (16) et préalablement au retrait sélectif des barreaux (101, 103, 105) à base du premier matériau (12), une formation de réservoirs de charges (DT1, DT2) à des extrémités de ladite structure (16), la formation des réservoirs de charges (DT1, DT2) comprenant:
- réaliser une gravure sélective partielle du premier matériau (12) vis-à-vis du deuxième matériau (14) afin de créer des évidements (41) au niveau desdites extrémités de ladite structure (16) d'empilement,
- combler lesdits évidements (41) par un matériau isolant afin de former des bouchons isolants (43) dans lesdites évidements,
- réaliser une épitaxie de matériau semi-conducteur (48) à partir d'extrémités dévoilées des barreaux (102, 104) à base du deuxième matériau (14), tandis que les barreaux (101, 103, 105) à base du premier matériau (12) sont protégées par les bouchons isolants (43).

14. Procédé selon l'une des revendications 11 à 13, dans lequel les motifs de grille de part et d'autre de ladite structure sont formés d'un matériau (22) de grille, le procédé comprenant en outre, après retrait sélectif des barreaux (101, 103, 105) à base du premier matériau (12), des étapes de :
- formation d'une encapsulation (52) isolante entre et autour des motifs (25) de grille,
- retrait partiel dudit matériau (22) de grille de sorte à conserver un bloc inférieur (GI) de matériau de grille et libérer des cavités (64) au-dessus de ce bloc inférieur de matériau de grille et entourées par l'encapsulation (52),
- remplir les cavités (64) d'au moins une couche isolante de sorte à former une zone d'isolation (ZI) sur le bloc inférieur (GI) de matériau (22) de grille puis,
- remplir les cavités (64) d'au moins une couche de matériau de grille, de sorte à former un bloc supérieur (GS) de matériau de grille sur la zone d'isolation (ZI).

15. Procédé selon la revendication 14, dans lequel après formation des motifs (25) de grille et avant formation de l'encapsulation, le procédé comprenant en outre des étapes de :
- formation d'un espaceur isolant réparti de manière conforme sur les motifs (25) de grilles et entre les motifs (25) de grille et agencé sur une zone centrale de ladite structure d'empilement.

16. Procédé selon l'une des revendications 14 ou 15, comprenant en outre des étapes de :
- retrait de l'encapsulation (52) isolante entre les motifs de grille ou entre les blocs de grille, de sorte libérer une ou plusieurs espaces,
- formation de grilles d'échange dans le ou les espaces.
